# EUROPEAN PATENT APPLICATION

(11) **EP 3 059 860 A1**
(43) Date of publication of application: **24.08.2016**
(21) Application number: 15156124.8
(22) Date of filing: 23.02.2015
(51) Int. Cl.: H03G 3/30, H03M 1/18

(54) **Automatic gain control circuit for communication signals**

(71) Applicant: Consulting Network GmbH, 85445 Oberding (DE)
(72) Inventor: Kukla, Hubert, 85445 Oberding (DE); Topal, Ibrahim, 85445 Oberding (DE); Datta, Subrata, 85445 Oberding (DE)
(74) Representative: MERH-IP Matias Erny Reichl Hoffmann Patentanwälte PartG mbB

(57) **Abstract**

This application relates to an automatic gain control circuit for processing a received communication signal that has been modulated to carry voice or data. The circuit comprises a plurality of parallel signal receiving paths and a path selector, wherein each signal receiving path receives a copy of the received communication signal and comprises an analog-to-digital converter and a sampling memory to store sampled signal values, at least one signal receiving path comprising a signal amplifier or signal attenuator to modify signal amplitudes of the communication signal before analog-to-digital conversion, and the path selector is configured to select one of the sampling memories for providing a sampled representation of the communication signal based on an examination of sampled signal values. The application further relates to receiver that comprises the automatic gain control circuit, and to a method of processing a received communication signal.

## Description

### Technical Field

The application relates to an automatic gain control circuit for processing a received communication signal, to a receiver for a communication system, and to a method of processing a received communication signal.

### Background

In communication systems that transmit a communication signal via radio, a signal level of the communication signal at a receiver may suffer from strong fluctuations. This may be due to e.g. movement of a transmitter and the receiver relative to each other and/or relative to obstacles that may attenuate the communication signal during its propagation from the transmitter to the receiver. However, analog-to-digital conversion of the received communication signal and subsequent demodulation of the communication signal require the signal level of the received communication signal to be within a given margin. Namely, if the signal level of the communication signal lies outside of the dynamic range of the receiver, demodulating the received communication signal is not possible, and the received information is lost. A retransmission of the lost information (e.g. in the form of packets) may be necessary, delaying and slowing down the overall transmission process. Such loss of information is particularly disadvantageous in communication systems that transmit communication signals carrying voice information or data, such as video data. For such communication systems, loss of information results in undesirable interruptions e.g. in reproducing the voice information or video data. Thus, real time reproduction of voice information or video data may be seriously impeded.

Conventionally, this issue is addressed by providing for automatic gain control at the receiver side. According to conventional automatic gain control, a control loop is provided for in which a gain (either amplification or attenuation) that is applied to the received communication signal is set to a given value, and the resulting signal level is measured and compared to a target signal level. By repeatedly running through the control loop, the gain may be set to an appropriate value.

However, the conventional technique only enables to set the gain for parts of the communication signal that will be received in the future, whereas parts of the communication signal that are received while running through the control loop are lost. In other words, information that is received while appropriately leveling out the gain is lost in conventional automatic gain control schemes.

Thus, there is a need for an improved automatic gain control scheme that avoids losing information while leveling out the gain that is to be applied to the received communication signal.

### Summary

In view of this need, the present document proposes an automatic gain control circuit for processing a received communication signal, a receiver comprising the automatic gain control circuit, and a method of processing a received communication signal, having the features of the respective independent claims.

An aspect of the disclosure relates to an automatic gain control circuit for processing a received communication signal. The communication signal may have been modulated to carry voice or data. For example, the communication signal may be modulated using QAM, QPSK or OFDM to carry payload data. Other modulation techniques may be applied as well. The circuit may comprise a plurality of parallel signal receiving paths and a path selector for selecting one of the plurality of parallel signal receiving paths. Each signal receiving path may receive a copy of the received communication signal. Further, each signal receiving path may comprise an analog-to-digital converter and a sampling memory to store sampled signal values. The sampling memories may relate to memory areas of a single memory, or may be provided as separate memory units. At least one signal receiving path may comprise a signal amplifier or signal attenuator to modify signal amplitudes (signal levels) of the communication signal before analog-to-digital conversion (ADC). Therein, the plurality of parallel signal receiving paths may have distinct gain factors to produce distinct amplification or attenuation of the signal amplitude of the respective copy of the communication signal. Thus, copies of the same communication signal with different signal levels may be sampled by different analog-to-digital converters and saved to respective sampling memories. The signal amplifiers or signal attenuators may be low-noise signal amplifiers or signal attenuators, respectively. The path selector may be configured to select one of the sampling memories (i.e. select one of the plurality of parallel signal receiving paths) for providing a sampled representation of the communication signal based on an examination of sampled signal values.

Configured as above, the automatic gain control circuit ensures that the communication signal is appropriately amplified or attenuated such that its signal level matches the dynamic range of one of the analog-to-digital converters, regardless of a signal level of the received communication signal. This is achieved by providing a plurality of parallel signal receiving paths applying distinct gains to respective copies of the received communication signal. By (dynamically) selecting an appropriate signal receiving path for providing the sampled representation of the communication signal, continuous output of a sampled representation of the communication signal that is suitable for subsequent demodulation is ensured. Since plural copies of the communication signal are processed in parallel by the plurality of parallel signal receiving paths, the automatic gain control circuit can react to sudden changes (fluctuations) in the signal level of the received communication signal without delay and without resulting loss of information. As such, the automatic gain control circuit can be advantageously applied to communication systems transmitting a communication signal carrying voice or data, such as video data, for example. For instance, the automatic gain control circuit may be employed for connecting spatially separated Ethernet local area networks (LANs) to each other via radio transmission, even in a case in which real time transmission of data is required between the spatially separated Ethernet LANs. Further, since the automatic gain control circuit described above can react to sudden changes of the signal level of the received communication signal in real time, it may be advantageously employed in mobile applications.

In embodiments, the path selector may be configured to detect signal clipping by examining sampled signal values, e.g. stored in the sampling memories. The path selector may be further configured to select a sampling memory based on detected signal clipping. Signal clipping may be understood to denote a case in which the amplitude of the signal (signal level) has a value that may not be reproduced by the number of bits provided for each sample in the analog-to-digital converter. For example, when the signal level is too large compared to the ADC operating range, the sample values will be the maximum value of the digital representation (e.g. 11111111 for an 8-bit conversion). On the other side, when the signal value is small compared to the ADC operating range, the sample values will be the minimum value (e.g. 00000000).

Further, a block of samples for a predetermined time period may be stored in each sampling memory. The path selector may be configured to select one of the sampling memories for providing the sampled representation of the communication signal for the predetermined time period. Therein, the path selector may cause the sampled signal values of the selected sampling memory to be read out from the selected sampling memory and provided as sampled representation of the communication signal for the predetermined time period.

In the above configuration, an appropriate one of the plurality of signal receiving paths that produces appropriate amplification (or attenuation) of the signal amplitude of the communication signal for allowing meaningful analog-to-digital conversion and subsequent demodulation of the communication signal may be determined and selected by the path selector. Accordingly, the communication signal can be appropriately demodulated for each time period, regardless of sudden changes (fluctuations) in the signal level of the received communication signal. The applied demodulation technique corresponds to the way that the communication signal was modulated in the transmitter.

In embodiments, the communication signal may be a continuously received signal and the time required by the path selector to select a sampling memory may be shorter than a time period corresponding to a portion (e.g. block) of the communication signal that is sampled and stored in the sampling memories. In embodiments, the communication signal may be transmitted based on packets or frames. The block size of sampled signal values may further correspond to the packet or frame size.

Thereby, loss of information is avoided, and continuous (i.e. real time) reproduction of the data carried by the communication signal is ensured at all times.

In embodiments, the analog-to-digital conversions and the storing of sampled signal values in the signal receiving paths may operate in parallel. Further, the path selector may examine sampled signal values while new signal values are analog-to-digital converted and stored.

By the above configuration, a time delay until an appropriate one of the sampling memories (i.e. an appropriate one of the signal receiving paths) is selected can be reduced.

In embodiments, each signal receiving path may further comprise a counting memory (e.g. an M-bit first-in-first-out (FIFO) memory, where M corresponds to the number of samples stored in sampling memory for each block) for storing a most significant bit (MSB) of each sampled signal value. Alternatively, a plurality of most significant bits for each sampled signal value may be stored in the counting memory. Examining the MSB allows a good estimate of signal clipping, in particular if a number of consecutive MSBs are all set to logical '1'. By considering not only the MSB but also further most significant bits for each signal value, an even better estimate for signal clipping can be made. The path selector may be configured to select a sampling memory based on the contents of the counting memories of the signal receiving paths.

In embodiments, each signal receiving path may further comprise a summing unit (e.g. a summation circuit) to sum the values of the most significant bits stored in the counting memory of the respective signal receiving path. The path selector may be configured to receive the summation results from the summing units and to select a sampling memory based on the summation results.

Accordingly, the path selector is capable of reliably and efficiently determining whether signal clipping has occurred for the sampled signal values that are stored in a given sampling memory. An appropriate one of the plurality of sampling memories can be selected based on the determination of whether signal clipping has occurred for the sampled signal values stored in the sampling memories.

In embodiments, the signal receiving paths may be arranged in a sequence (i.e. an ordered sequence) and may be configured such that signal amplification or attenuation is increasing or decreasing from one signal receiving path to the next signal receiving path in said ordered sequence. In other words, the signal receiving paths may be ordered in a sequence in which the gain factor increases from one signal receiving path to the next signal receiving path in the sequence, from a signal receiving path having a smallest gain factor to a signal receiving path having the largest gain factor, or vice versa. In a similar way, signal attenuations can be included in said ordered sequence.

Accordingly, the sampled signal values stored in the sampling memories can be examined in an orderly manner. In the case of continuous changes in the signal level of the received communication signal, a signal receiving path that has been found appropriate for a given block of the communication signal can be used as the starting point for examining the sampled signal values stored in the sampling memories for the next block of the communication signal. Thereby, the number of examination steps of sampled signal values stored in sampling memories that are necessary for each block of the communication signal to select the appropriate signal receiving path can be reduced and overall efficiency of the automatic gain control circuit is improved.

In embodiments, the automatic gain control circuit may further comprise at least a second set of sampling memories for the signal receiving paths. The sets of sampling memories may be sequentially used to store sampling values of the communication signal for a time period.

Thereby, parallel processing of sampled signal values stored in the two sets of sampling memories is enabled. Thus, even if the delay for selecting the appropriate sampling memory should exceed the time period corresponding to a length of a block of the communication signal for some reason, loss of information is avoided.

Another aspect of the disclosure relates to a receiver for a communication system. The receiver may comprise the automatic gain control circuit of the above aspect. The receiver may further comprise a signal demodulation unit coupled with the automatic gain control circuit. The signal demodulation unit may be configured to receive a sampled representation of the received communication signal from the selected sampling memory and to demodulate the sampled signal values to recover the carried voice or data information.

Another aspect of the disclosure relates to a method of processing a received communication signal that has been modulated to carry voice or data. The method may comprise receiving the communication signal in parallel in a plurality of signal receiving paths. The method may further comprise selectively amplifying or attenuating the received communication signal in at least one signal receiving path. The method may further comprise analog-to-digital converting the communication signal or an amplified or attenuated version of the communication signal in each signal receiving path. The method may further comprise storing sampled signal values corresponding to the communication signal in respective sampling memories of the signal receiving paths. The method may further comprise selecting one of the signal receiving paths. The method may yet further comprise reading the sampled signal values from the sampling memory of the selected signal receiving path. The selecting of a signal receiving path may comprise examining sampled signal values.

In embodiments, the selecting of a signal receiving path may be based on a determination whether sampled signal values stored in the sampling memories of the signal receiving paths are clipped in value, i.e. whether signal clipping has occurred.

In embodiments, signal amplification or attenuation in the signal receiving paths may be configured such that signal amplification is decreasing from one signal receiving path to the next signal receiving path. The selecting of a signal receiving path may comprise sequentially determining whether sampled signal values stored in the sampling memory of a signal receiving path are clipped and selecting the first determined signal receiving path having no or only a small number of clipped sampled signal values.

In embodiments, the method may further comprise determining the most significant bit (MSB) of each sampled signal value and storing the total number of most significant bits that have a logical '1' for each signal receiving path. Then, the selecting of a signal receiving path may optionally comprise comparing the total number of most significant bits that have a logical '1' of a signal receiving path with a threshold. Likewise, the total number of most significant bits that have a logical '0' may be stored for each signal path and optionally compared with a threshold. In general, the total number of most significant bits that have a given logical value (i.e. either '0' or '1') may be stored for each signal path and optionally compared with a threshold. The method may further comprise determining that clipping is present for the signal receiving path in question if the total number of most significant bits that have the logical '1' is above the respective threshold, or if the total number of most significant bits that have the logical '0' is below the respective threshold.

In embodiments, the method may further comprise demodulating the sampled signal values to recover the carried voice or data information.

It will be appreciated that method steps and apparatus features may be interchanged in many ways. In particular, the details of the disclosed apparatus can be implemented as a method, as the skilled person will appreciate.

### Brief Description of the Figures

Embodiments of the disclosure are explained below in an exemplary manner with reference to the accompanying drawings, wherein
**Fig. 1** schematically illustrates an example of an automatic gain control circuit according to embodiments of the disclosure,
**Fig. 2** schematically illustrates an example of a flowchart of a procedure for selecting one of a plurality of parallel signal receiving paths of the automatic gain control circuit,
**Fig. 3** schematically illustrates another example of an automatic gain control circuit according to embodiments of the disclosure, and
**Fig. 4** schematically illustrates another example of a flowchart of a procedure for selecting one of a plurality of parallel signal receiving paths of the automatic gain control circuit.

### Detailed Description

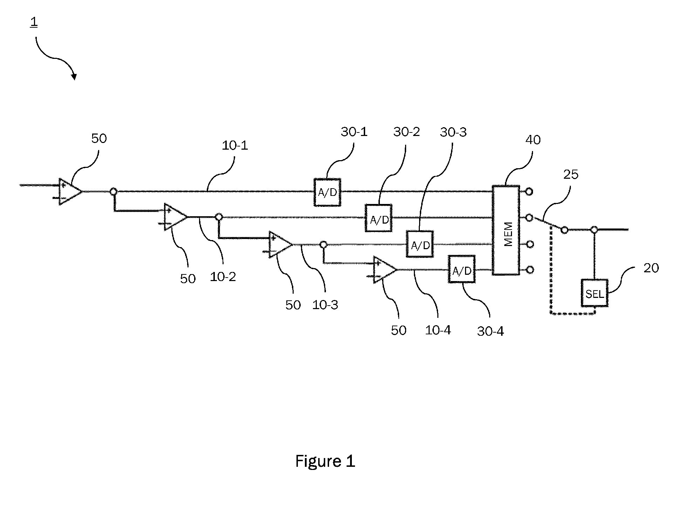

**Fig. 1** schematically illustrates an example of an automatic gain control (AGC) circuit 1 according to embodiments of the disclosure. In a broad sense, differently amplified/attenuated digitized versions of the received signal are saved and the decision which version to use is made based on the saved signal.

Thus, the same received signal with different signal levels is sampled by different ADCs and saved. Different algorithms and/or properties of the ADC can be used to decide which sampled to use for further processing.

The automatic gain control circuit 1 may comprise a plurality of parallel signal receiving paths 10-1, 10-2, 10-3, 10-4 (the signal receiving paths will be jointly denoted by reference numeral 10 unless a distinction between signal receiving paths is necessary). Each of the parallel signal receiving paths 10 may receive a copy of a received communication signal, which may be a communication signal that has been modulated to carry voice or data, e.g. video data. Further, at least one of the parallel signal receiving paths 10 may comprise a signal amplifier 50 or a signal attenuator to modify a signal amplitude (signal level) of the respective copy of the received communication signal. In the example of **Fig. 1****,** only signal amplifiers 50 are shown. However, some or all of these signal amplifiers 50 may be replaced by signal attenuators. Further, in the example of **Fig. 1** signal amplifiers are shown to be shared between signal receiving paths 10, e.g. the signal amplifier 50 to the top-left in **Fig. 1** is comprised by each of the plurality of parallel signal receiving paths 10. However, signal amplifiers and/or signal attenuators may be uniquely allocated to distinct signal receiving paths 10. Notably, one of the signal receiving paths 10 may have zero gain.

Optionally, a signal filter at the input of the AGC circuit 1 may be provided to filter the input signal according to characteristics of the communication channel and the communication signal such as used frequency band, bandwidth, etc. In addition, further signal processing components may be provided such as for decoding, error correction, etc.

As indicated above, at least one of the signal receiving paths 10 may comprise a signal amplifier 50 or a signal attenuator. More specifically, the signal receiving paths may be provided with signal amplifiers 50 or signal attenuators in such a manner that distinct gains (either positive or negative, or zero) are applied to the signal levels of respective copies of the received communication signal. In other words, the signal receiving paths 10 may have distinct gains. In such configuration, the signal receiving paths 10 may be (logically) ordered in a sequence in which the gain increases (or alternatively, decreases) from one signal receiving path 10 to the next signal receiving path in the sequence. For instance, a first signal receiving paths 10-1 may have the largest gain, a second signal receiving path 10-2 may have smaller gain (less positive or more negative) than the first signal receiving path 10-1, and so forth.

Each signal receiving path may further comprise an analog-to-digital converter 30-1, 30-2, 30-3, 30-4 (the analog-to-digital converters will be jointly denoted by reference numeral 30 unless a distinction between analog-to-digital converters is necessary) arranged downstream of respective signal amplifier(s) 50 or signal attenuators(s). The analog-to-digital converters 30 may be adapted to receive respective copies of the received communication signal, optionally after amplification or attenuation, and to subject said respective copies of the received communication signal to analog-to-digital conversion. The analog-to-digital converters 30 may be adapted to output sampled signal values representing respective copies of the received communication signal, optionally after amplification or attenuation.

Each signal receiving path 10 may further comprise a sampling memory 40 arranged downstream of the respective analog-to-digital converter 30. Therein, the sampling memories 40 may correspond to memory areas of a single memory, as shown in **Fig. 1****,** or they may correspond to distinct memories. The sampling memories 40 may be configured to receive and store the sampled signal values that are output by respective analog-to-digital converters 30.

Since the copies of the received communication signal are subjected to application of different gains before being subjected to analog-to-digital conversion, information carried by the communication signal is not lost even after a sudden change of signal level of the communication signal. The reason is that (for appropriate choice of amplification or attenuation in the signal receiving paths 10) at least one of the analog-to-digital converters 30 is supplied with an input signal matching its dynamic range.

The automatic gain control circuit 1 may further comprise a path selector 20. The path selector 20 may be configured to select one of the sampling memories 40 (i.e. select one of the signal receiving paths 10) for providing, as an output of the automatic gain control circuit 1, a sampled representation of the received communication signal. The sampled representation of the received communication signal corresponds to the sampled signal values stored by the selected sampling memory 40. For example, the sampling memories 40 may store a block of samples corresponding to a predetermined period of time, and the path selector 20 may be configured to select the one of the sampling memories 40 for providing block of samples as the sampled representation of the received communication signal for the predetermined period of time. That is, the path selector 20 may cause the sampled signal values that are stored in the selected sampling memory 40 to be read out and to be provided as sampled representation of the received communication signal for the predetermined period of time. To this end, the automatic gain control circuit 1 may comprise a switching means 25 controlled by the path selector 20, for selectively providing the read out of a given sampling memory to an output terminal of the automatic gain control circuit 1.

The communication signal may be continuously received. The time (duration) that is required by the path selector 20 for selecting the one of the sampling memories 40 may be shorter than a period of time corresponding to a portion of the communication signal (e.g. a block) that is sampled and stored in the sampling memories 40. Accordingly, a continuous stream of data may be output by the automatic gain control circuit 1, and interruptions in the demodulated signal that is generated from the output of the automatic gain control circuit 1 are avoided. In other words, the voice or data carried by the communication signal may be demodulated in real time.

In order to select the one of the sampling memories 40, the path selector 20 may examine, for each sampling memory 40, the sampled signal values stored in the respective sampling memory 40, and may select the one of the sampling memories 40 based on a result of the examination. Therein, the analog-to-digital converters 30 may operate in parallel to the storing of the sampled signal values in the sampling memories 40, such that the sampled signal values stored in the sampling memories 40 may be examined while new sampled signal values are analog-to-digital converted and stored. An example of a process for selecting the one of the sampling memories 40 will be described in more detail below.

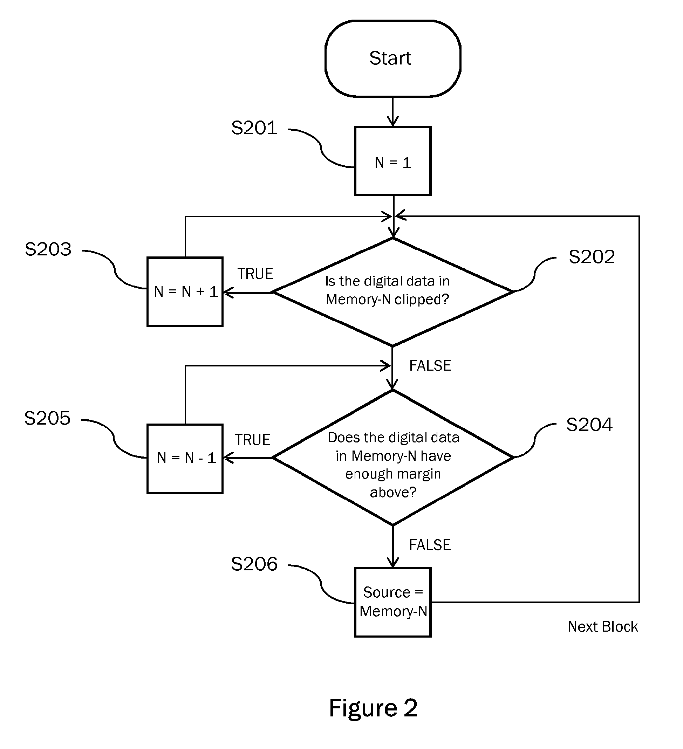

**Fig. 2** schematically illustrates an example of a flowchart of a procedure for selecting one of a plurality of parallel signal receiving paths (i.e. one of the plurality of sampling memories 40) of the automatic gain control circuit. This procedure may be executed by the path selector 20. In the figure, N is an ordinal number indicating a respective sampling memory 40 (or a respective signal receiving path 10) in the ordered sequence of signal receiving paths 10, which is ordered in accordance with increasing (or decreasing gain). In the example of **Fig. 2****,** said sequence is ordered in the order of decreasing gain for increasing ordinal number, i.e. A_{N+1} < AN for Aᵢ denoting the gain of the i-th signal receiving path.

In the example of **Fig. 2****,** the path selector 20 may be configured to detect signal clipping of the received communication signal that has occurred in the process of analog-to-digital conversion, by examining sampled signal values that are stored in the sampling memories 40. The path selector 20 then may select the one of the sampling memories 40 based on detected signal clipping.

At step S201, N is initialized to 1, corresponding to the signal receiving path 10 providing the highest gain.

At step S202, it is determined whether signal clipping has occurred for the sampled signal values in the N-th sampling memory 40. An example of a procedure for determining whether signal clipping has occurred will be described in more detail below.

If signal clipping has occurred for the sampled signal values stored in the N-th sampling memory (TRUE at step S202), N is incremented by 1 at step S203, and the procedure returns to step S202. On the other hand, if clipping has not occurred for the sampled signal values stored in the N-th sampling memory (FALSE at step S202), the procedure proceeds to step S204.

At step S204, it is determined whether the digital data (i.e. the sampled signal values) stored in the N-th sampling memory 40 has a given margin above. In other words, it may be determined whether an average or peak value of the sampled signal values is a given margin below a maximum signal level representable by the number of bits in each sampled signal value.

If there is a given margin above (TRUE at step S204), the procedure decrements N by 1 at step S205 and returns to step S204. On the other hand, if there is not a given margin above (FALSE at step S204), the procedure proceeds to step S206.

At step S206, the N-th sampling memory 40 is selected as the one of the sampling memories 40 for providing a sampled representation of the communication signal (e.g. for the predetermined period of time).

The procedure then returns to step S202 for the next block of the communication signal, e.g. for the next predetermined period of time. Notably, N is not initialized to 1 for the next block, but the previous value of N is retained as the starting value. Incidentally, if N were initialized to 1 in an alternative implementation, steps S204 and S205 could be omitted.

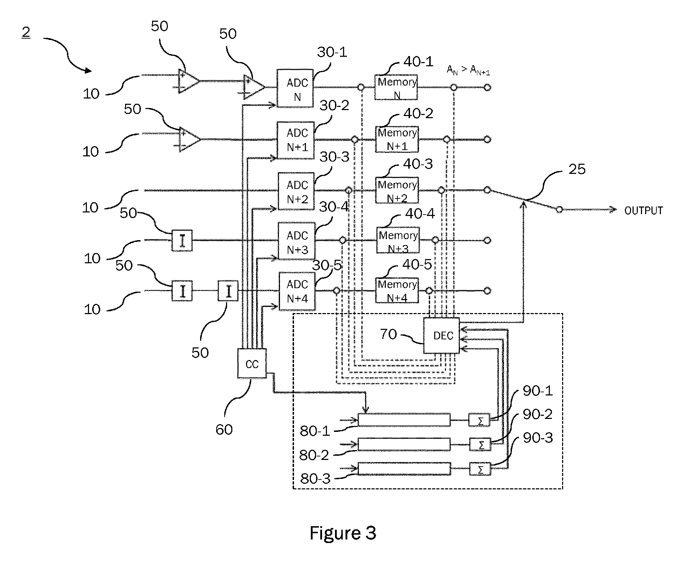

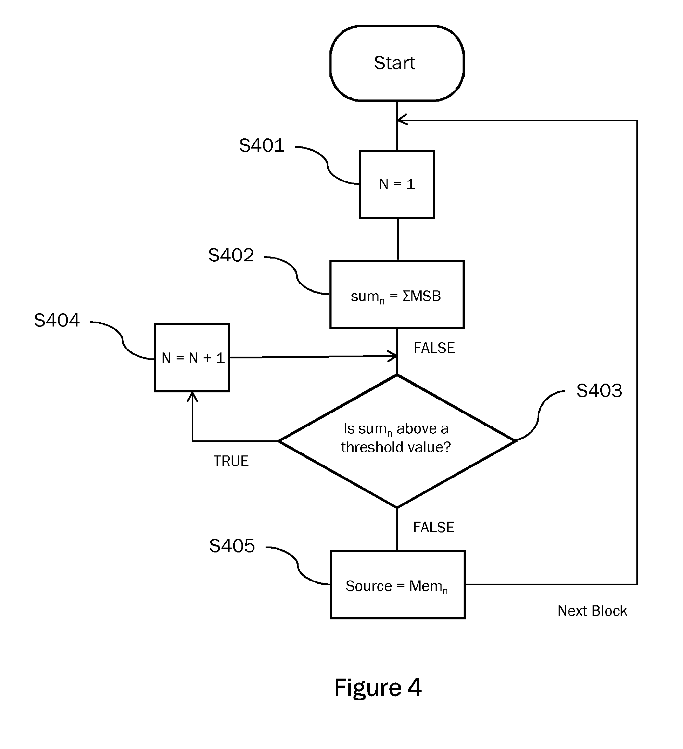

A procedure for determining whether clipping has occurred and whether there is a given margin above for the sampled signal value stored in the sampling memory 40 will now be described with reference to **Fig. 3** and **Fig. 4****.** **Fig. 3** schematically illustrates another example of an automatic gain control circuit 2 according to embodiments of the disclosure. Unless indicated otherwise, like-numbered elements in **Fig. 3** correspond to those in **Fig. 1****,** and respective explanations apply.

In a broad sense, the circuit of **Fig. 3** operates as follows. The incoming signal is run through different parallel paths with different amplifications/attenuations. Each signal is digitized by an independent ADC and M samples are stored in memory from each ADC to hold a block of data. Simultaneously, the MSBs of each sample will be stored in an M-bit FIFO. If the value of the elements of the FIFO exceeds a threshold, a clipping decision will be made for that block. The first FIFO with no clipping will be chosen as the correct path and will be sent to output. Evaluation of the next block will be started.

The automatic gain control circuit 2 may comprise a plurality of parallel signal receiving paths 10-1, ..., 10-5, at least one of them provided with one or more signal amplifiers 50 or signal attenuators 50. Each signal receiving path 10 may comprise an analog-to-digital converter 30-1, ..., 30-5 and a sampling memory 40-1, ..., 40-5. The automatic gain control circuit 2 may further comprise a path selector 20.

While the above elements correspond to the ones illustrated in and described with reference to **Fig. 1****,** the automatic gain control circuit 2 of **Fig. 3** differs from the automatic gain control circuit 1 of **Fig. 1** in the specific implementation of the path selector 20, and may further comprise a clock circuit 60 for synchronizing the analog-to-digital converters 30. Notably, the path selector 20 in **Fig. 3** is configured to perform the actions described above with reference to **Fig. 1** and **Fig. 2****.**

The path selector 20 may comprise a decision circuit 70 (e.g. implemented by a microprocessor) and a plurality of counting memories 80-1, 80-2, 80-3, e.g. a plurality of M-bit FIFO memories 80-1, 80-2, 80-3 (the M-bit FIFO memories will be jointly denoted by reference numeral 80 unless a distinction between M-bit FIFO memories is necessary). Although **Fig. 3** only shows three M-bit FIFO memories (counting memories) 80, the number of M-bit FIFO memories 80 may correspond to the number of signal receiving paths 10. The path selector 20 may further comprise a plurality of summing units (e.g. summation circuits) 90-1, 90-2, 90-3 (the summation circuits will be jointly denoted by reference numeral 90 unless a distinction between summation circuits is necessary) connected to respective M-bit FIFO memories (counting memories) 80. Although **Fig. 3** only shows three summation circuits 90, the number of summation circuits 90 may correspond to the number of signal receiving paths 10 and the number of M-bit FIFO memories 80.

As in the case of **Fig. 1****,** a copy of the incoming communication signal is provided to each signal receiving path 10 and is run through respective signal receiving paths 10 to receive respective amplification or attenuation. Again, each copy of the communication signal, after respective amplification or attenuation may be subjected to analog-to-digital conversion in a respective analog-to-digital converter 30, and sampled signal values may be stored in a respective sampling memory 40. Simultaneously, for each signal receiving path 10, the most significant bits (MSBs) may be stored in a respective M-bit FIFO memory 80. This storing of MSBs in the M-bit FIFO memories 80 may proceed under control of the decision circuit 70. For each M-bit FIFO memory 80, the corresponding summation circuit 90 may sum the values of the MSBs stored in the M-bit FIFO memory. Such configured, the corresponding summation circuit 90 may output the number of MSBs in the M-bit FIFO memory 80 that have a logical '1'.

A decision as to whether signal clipping has occurred for the sampled signal values in a respective sampling memory 40 may be performed based on examination of the sum of values of the MSBs stored in the corresponding M-bit FIFO memory 80. This may involve comparing said sum to a threshold value, and deciding that signal clipping has occurred for the sampled signal values stored in the respective sampling memory 40 if said sum exceeds the threshold value.

In this configuration, the sampled signal values stored in each sampling memory 40 may be examined, e.g. in order from the sampling memory 40 corresponding to the signal receiving path 10 having the highest gain to the sampling memory 40 corresponding to the signal receiving path 10 having the lowest gain, and the first sampling memory 40 for which it is found that signal clipping has not occurred may be selected as the one of the sampling memories 40 for providing a sampled representation of the communication signal.

Thus, the decision circuit 70 (or more general, the path selector 20) may be said to select the one sampling memory 40 for providing a sampled representation of the communication signal based on the respective contents of the M-bit FIFO memories (counting memories) 80. More specifically, the decision circuit 70 (or more general, the path selector 20) may be said to select the one sampling memory 40 for providing a sampled representation of the communication signal based on the summation results of the summation circuits (summing units) 90.

**Fig. 4** schematically illustrates another example of a flowchart of a procedure for selecting one of a plurality of parallel signal receiving paths of the automatic gain control circuit. This procedure may be executed by the path selector 20. In the figure, N is an ordinal number indicating a respective sampling memory 40 (or a respective signal receiving path 10) in the ordered sequence of signal receiving paths 10, ordered in accordance with increasing (or decreasing) gain. In the example of **Fig. 4****,** said sequence is ordered in the order of decreasing gain for increasing ordinal number, i.e. A_{N+1} < AN for Aᵢ denoting the gain of the i-th signal receiving path.

At step S401, N is initialized to 1, corresponding to the signal receiving path 10 providing the highest gain.

At step S402, sums of the MSBs stored in each M-bit FIFO memory 80 are determined by corresponding summation circuits 90. Alternatively, only the sum of the MSBs stored in the (N-th) M-bit FIFO memory 80 corresponding to the N-th sampling memory 40 (i.e. corresponding to the N-th signal receiving path 10) may be determined by the corresponding (N-th) summation circuit 90. In the former case, the procedure returns to step S403 after step S404 has been performed (see below), while in the latter case, it returns to step S402 after step S404 has been performed. **Fig. 4** exemplarily illustrates the former case.

At step S403, the determined sum is compared to a predetermined threshold value. If the determined sum is found to exceed the threshold value (TRUE at step S403), N is incremented by 1 at step S404 and the procedure returns to step S403. On the other hand, if the determined sum is found to not exceed the threshold value (FALSE at step S403), the procedure proceeds to step S405.

In the above, steps S402 and S403 represent an implementation of a detecting signal clipping for the sampled signal values stored in the N-th sampling memory 40, as performed at step S202 in **Fig. 2****.** If the determined sum (i.e. the number of MSBs having a logical '1') exceeds the threshold value, it may be determined that signal clipping has occurred for the sampled signal values stored in the N-th sampling memory 40.

At step S405, the N-th sampling memory 40 is selected as the one of the sampling memories 40 for providing the sampled representation of the communication signal (e.g. for the predetermined period of time).

The procedure then returns to step S401 for the next block of the communication signal, e.g. for the next predetermined period of time.

In an alternative implementation, N may not be initialized to 1 after performing step S405, and the procedure may return to step S402 after performing step S405, keeping N at its present value. In this case, the procedure may further comprise an additional step S406 after step S403 and before step S405 of comparing the determined sum to a second predetermined threshold value. If the determined sum is found to exceed the second threshold value, the procedure proceeds to step S405. On the other hand, if the determined sum is found to not exceed the second threshold value, N is decremented by 1 and the procedure returns to step S406. In case that the sum of MSBs in the M-bit FIFO memory 80 corresponding to the N-th signal receiving path 10 (for N decremented by 1) has not yet been determined, said determination is performed by the corresponding summation circuit 90 before returning to step S406. The second threshold value may be smaller than the threshold value.

In the above, step S406 represents an implementation of said determination of whether the digital data (i.e. the sampled signal values) stored in the N-th sampling memory 40 has a given margin above, as performed in step S204 of **Fig. 2****.** If the determined sum (i.e. the number of MSBs having a logical '1') does not exceed the second threshold value, it may be determined that the sampled signal values stored in the N-th sampling memory 40 have the given margin above.

Each of the automatic gain control circuits 1, 2 illustrated in **Fig. 1** or **Fig. 3** may further comprise at least a second set of sampling memories (not illustrated in **Fig. 1** and **Fig. 3**). The sets of sampling memories may be sequentially used to store sampling values of the communication signal for a period of time.

The automatic gain control circuits 1, 2 illustrated in **Fig. 1** or **Fig. 3** may be comprised by a receiver for a communication system. Said receiver may further comprise a signal demodulation unit, coupled to and receiving an output of the automatic gain control circuit 1, 2. The signal demodulation unit may be configured to receive the sampled representation of the communication signal output by the automatic gain control circuit 1, 2 (e.g. the sampled signal values read out from the selected one of the sampling memories 40), and to demodulate the sampled signal values to recover the voice or data carried by the communication signal.

The above-suggested AGC circuits and the disclosed receiver may be employed in various communication systems such as in transparent LAN extenders which link two LANs over the air. Due to the no-loss property of the AGC, no or at least significantly reduced retransmissions are necessary so that delay and latency of data transmission is reduced, which makes the proposed approach particular suitable for real time transmission of media data such as voice or video. The disclosed AGC circuits and receiver can operate for packet based transmissions such as according to the Ethernet specifications.

It should be noted that the apparatus features described above correspond to respective method features that may however not be explicitly described, for reasons of conciseness, and vice versa. The disclosure of the present document is considered to extend also to such method features and apparatus features, respectively.

It should further be noted that the description and drawings merely illustrate the principles of the proposed apparatus. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed apparatus. Furthermore, all statements herein providing principles, aspects, and embodiments of the invention, as well as specific examples thereof, are intended to encompass equivalents thereof.

## Claims

1. Automatic gain control circuit for processing a received communication signal that has been modulated to carry voice or data, the circuit comprising a plurality of parallel signal receiving paths and a path selector, wherein
each signal receiving path receives a copy of the received communication signal and comprises an analog-to-digital converter and a sampling memory to store sampled signal values, at least one signal receiving path comprising a signal amplifier or signal attenuator to modify signal amplitudes of the communication signal before analog-to-digital conversion; and
the path selector is configured to select one of the sampling memories for providing a sampled representation of the communication signal based on an examination of sampled signal values.

2. The automatic gain control circuit of claim 1, wherein the path selector is configured to detect signal clipping by examining sampled signal values, and to select a sampling memory based on detected signal clipping.

3. The automatic gain control circuit of claim 1 or 2, wherein a block of samples for a predetermined time period is stored in each sampling memory, wherein the path selector is configured to select one of the sampling memories for providing a sampled representation of the communication signal for the predetermined time period.

4. The automatic gain control circuit of any one of the previous claims, wherein the communication signal is a continuously received signal and the time required by the path selector to select a sampling memory is shorter than a time period corresponding to a portion of the communication signal that is sampled and stored in the sampling memories.

5. The automatic gain control circuit of any one of the previous claims, wherein the analog-to-digital conversions and the storing of sampled signal values in the signal receiving paths operate in parallel, and the path selector examines sampled signal values while new signal values are analog-to-digital converted and stored.

6. The automatic gain control circuit of any one of the previous claims, wherein each signal receiving path further comprises a counting memory for storing a most significant bit of each sampled signal value, and the path selector is configured to select a sampling memory based on the contents of the counting memories of the signal receiving paths.

7. The automatic gain control circuit of claim 6, wherein each signal receiving path further comprises a summing unit to sum the values of the most significant bits stored in the counting memory of the respective signal receiving path, and the path selector is configured to receive the summation results from the summing units and to select a sampling memory based on the summation results.

8. The automatic gain control circuit of any one of the previous claims, wherein the signal receiving paths are arranged in a sequence and are configured such that signal amplification or attenuation is increasing or decreasing from one signal receiving path to the next signal receiving path in said sequence.

9. The automatic gain control circuit of any one of the previous claims, further comprising at least a second set of sampling memories for the signal receiving paths, wherein the sets of sampling memories are sequentially used to store sampling values of the communication signal for a time period.

10. Receiver for a communication system, comprising
the automatic gain control circuit of any one of the previous claims; and
a signal demodulation unit coupled with the automatic gain control circuit, configured to receive a sampled representation of the received communication signal and to demodulate the sampled signal values to recover the carried voice or data information.

11. The method of processing a received communication signal that has been modulated to carry voice or data, the method comprising
receiving the communication signal in parallel in a plurality of signal receiving paths;
selectively amplifying or attenuating the received communication signal in at least one signal receiving path;
analog-to-digital converting the communication signal or an amplified or attenuated version of the communication signal in each signal receiving path;
storing sampled signal values corresponding to the communication signal in respective sampling memories of the signal receiving paths;
selecting one of the signal receiving paths; and
reading the sampled signal values from the sampling memory of the selected signal receiving path,
wherein the selecting of a signal receiving path comprises examining sampled signal values.

12. The method of claim 11, wherein the selecting of a signal receiving path is based on a determination whether sampled signal values stored in the sampling memories of the signal receiving paths are clipped in value.

13. The method of claim 11 or 12, wherein signal amplification or attenuation in the signal receiving paths is configured such that signal amplification is decreasing from one signal receiving path to the next signal receiving path, wherein the selecting of a signal receiving path comprises sequentially determining whether sampled signal values stored in the sampling memory of a signal receiving path are clipped and selecting the first determined signal receiving path having no or only a small number of clipped sampled signal values.

14. The method of any one of claims 11 to 13, further comprising determining the most significant bit of each sampled signal value and storing the total number of most significant bits that have a logical '1' for each signal receiving path, wherein the selecting of a signal receiving path optionally comprises comparing the total number of most significant bits that have said logical '1' of a signal receiving path with a threshold.

15. The method of any of claims 11 to 14, further comprising demodulating the sampled signal values to recover the carried voice or data information.
